# EUROPEAN PATENT APPLICATION

(11) **EP 4 783 409 A1**
(43) Date of publication of application: **29.07.2026**
(21) Application number: 25864528.2
(22) Date of filing: 04.06.2025
(51) Int. Cl.: H02J 7/00, H04L 67/12, G01R 31/3842, G01R 31/392, H01M 10/42, H01M 10/48

(54) **ENERGY STORAGE BATTERY MANAGEMENT SYSTEM**

(30) Priority: 04.12.2024 CN 202411779010
(71) Applicant: Eve Energy Co., Ltd., Huizhou, Guangdong 516006 (CN)
(72) Inventor: YU, Pancheng, Huizhou, Guangdong 516006 (CN)
(74) Representative: Vossius & Partner Patentanwälte Rechtsanwälte mbB
(86) International application number: PCT/CN2025/099175
(87) International publication number: WO 2026/118402

(57) **Abstract**

An energy storage battery management system includes a power isolation unit, a high-voltage acquisition unit and a communication isolation unit. The power isolation unit can subject an initial low-voltage signal to primary isolation by a first transformer and secondary isolation by a second transformer in sequence to obtain a second voltage, and convert the second voltage to a target operating voltage for the high-voltage acquisition unit. The high-voltage acquisition unit can acquire and convert battery cluster information into a digital signal format. The communication isolation unit can transmit the battery cluster information in the digital signal format to a microcontroller unit (MCU) through primary isolation by a third transformer and secondary isolation by a fourth transformer in sequence, to enable the MCU to generate a control instruction for the battery cluster based on the battery cluster information.

## Description

### CROSS-REFERENCE TO RELATED APPLICATIONS

This application claims priority to Chinese Patent Application No. 202411779010.X, filed with the Chinese Patent Office on December 4, 2024. The disclosure of the abovementioned application is incorporated herein by reference in its entirety.

### TECHNICAL FIELD

The present application relates to battery management technologies, and in particular to energy storage battery management systems.

### BACKGROUND

An energy storage battery management system is an important component of an energy storage system, and can perform status detection, status prediction, status warning and the like on energy storage batteries of the energy storage system by monitoring parameters of the energy storage batteries in real time, so as to monitor, manage and maintain the energy storage batteries and ensure reliable operations thereof. Consequently, with the energy storage battery management system, the service life of the energy storage batteries can be extended, and the utilization efficiency and economic value thereof can be improved.

Typically, the energy storage battery management system may have a management voltage up to 1500V. If the management voltage is increased to 2000V, the energy storage battery management system will have an improved system cycle efficiency. From the perspective of the cost-effectiveness of the energy storage system, the energy storage battery management system with the management voltage ranging from 2000V to 2500V is more advantageous than the energy storage battery management system with the management voltage up to 1500V.

If the management voltage of the energy storage battery management system is increased to 2000V-2500V, in the energy storage system, the number of components connected in series will increase, the amount of direct current (DC) cables connected to the inverter will decrease, and the number of combiner boxes will decrease accordingly. Moreover, each electrical device such as a combiner box, an inverter, or a box transformer will have an increased power density and a decreased size, so that the workload for transporting and maintaining the electrical device may be reduced. Thus, the overall cost of the energy storage system may be lowered. On the other hand, as the voltage of the energy storage system increases, the total voltage of the battery pack acquired by the energy storage battery management system as the core of the energy storage system will also increase. Therefore, there is a need for a new high-low voltage isolation to improve the level of the management voltage of the energy storage battery management system.

### SUMMARY

According to some embodiments of the present application, an energy storage battery management system includes a power isolation unit, a high-voltage acquisition unit and a communication isolation unit. The power isolation unit includes a first transformer and a second transformer and is configured to: subject an initial low-voltage signal to primary isolation by the first transformer and secondary isolation by the second transformer in sequence, to obtain a second voltage; convert the second voltage to a target operating voltage of the high-voltage acquisition unit; and supply the target operating voltage to the high-voltage acquisition unit. The high-voltage acquisition unit is configured to: acquire battery cluster information of a battery cluster; convert the battery cluster information into a digital signal format; and provide the battery cluster information in the digital signal format to the communication isolation unit. The communication isolation unit includes a third transformer and a fourth transformer and is configured to: transmit the battery cluster information in the digital signal format to a microcontroller unit (MCU) through primary isolation by the third transformer and secondary isolation by the fourth transformer in sequence, to enable the MCU to generate a control instruction for the battery cluster based on the battery cluster information.

### BRIEF DESCRIPTION OF THE DRAWINGS

FIG. 1 is a schematic block diagram of an energy storage battery management system according to some embodiments of the present application.
FIG. 2 is a schematic circuit diagram of an energy storage battery management system according to some embodiments of the present application.
FIG. 3 is a flowchart of a power isolation method in an energy storage battery management system according to some embodiments of the present application.
FIG. 4 is a flowchart of a communication isolation method in an energy storage battery management system according to some embodiments of the present application.

### DETAILED DESCRIPTION

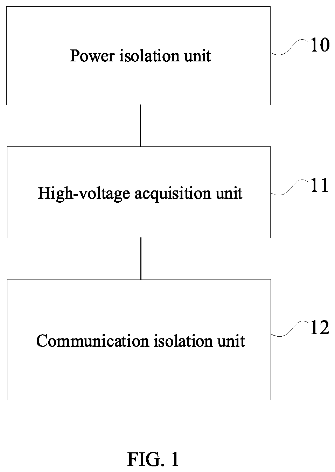

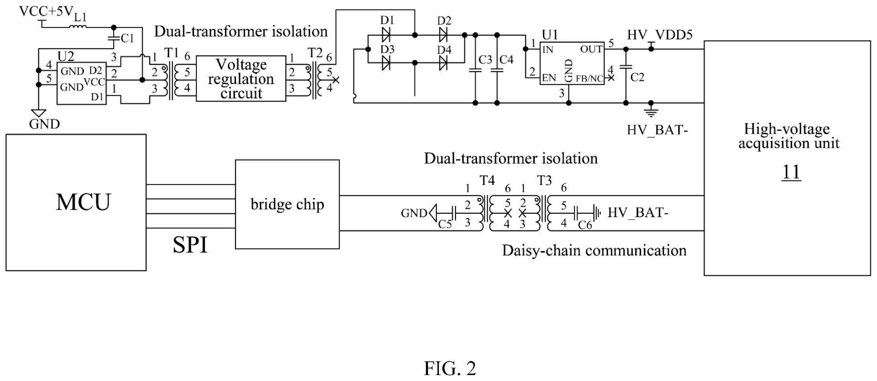

FIG. 1 is a schematic block diagram of an energy storage battery management system according to some embodiments of the present application. FIG. 2 is a schematic circuit diagram of an energy storage battery management system according to some embodiments of the present application. As shown in FIG.1 and FIG. 2, the energy storage battery management system may include a power isolation unit 10, a high-voltage acquisition unit 11 and a communication isolation unit 12.

According to some embodiments, the power isolation unit 10 is configured to provide a target operating voltage for the high-voltage acquisition unit 11. The power isolation unit 10 may include a low-voltage power supply VCC (having a voltage such as +5V), a first transformer T1 serving as primary isolation module of the power isolation unit 10, a voltage regulation circuit, a second transformer T2 serving as secondary isolation module of the power isolation unit 10, a diode module, and a voltage stabilizer U1. Upon receiving a voltage signal generated by the low-voltage power supply VCC, the first transformer T1 couples the voltage signal to the voltage regulation circuit. The second transformer T2 is configured to couple an output voltage signal from the voltage regulation circuit to the diode module. An output voltage from the diode module is processed by the voltage stabilizer U1 to obtain the target operating voltage supplied to the high-voltage acquisition unit 11.

The high-voltage acquisition unit 11 is configured to acquire battery cluster information in an analog signal format, convert the battery cluster information into a digital signal format, and transmits the battery cluster information in the digital signal format to the communication isolation unit 12.

The communication isolation unit 12 is configured to transmit the battery cluster information in the digital signal format to a microcontroller unit (MCU), enabling the MCU to generate a control instruction for the battery cluster based on this battery cluster information. The communication isolation unit 12 may include a third transformer T3 serving as primary isolation module of the communication isolation unit 12, a fourth transformer T4 serving as secondary isolation module of the communication isolation unit 12, and a bridge chip. The third transformer T3 is configured to couple the battery cluster information in the digital signal format to the fourth transformer T4. The fourth transformer T4 is configured to couple the battery cluster information in the digital signal format to the bridge chip. The bridge chip is configured to transmit the battery cluster information in the digital signal format to the MCU.

Within the power isolation unit 10 according to some embodiments, the low-voltage power supply VCC is configured to provide an initial voltage signal for the power isolation unit 10 and may utilize ±5V AC power. The first transformer T1 and the second transformer T2 may employ transformers with a 1:2 turns ratio or transformers with a 1:1 turns ratio. It should be noted that a creepage distance of each of the first transformer T1 and the second transformer T2 must be greater than or equal to a preset insulation threshold, and a sum of the creepage distances of the first transformer T1 and the second transformer T2 must be greater than or equal to a target insulation threshold for a dual-transformer configuration. In the embodiments, the first transformer T1 may serve as the primary isolation module of the power isolation unit 10, while the second transformer T2 may serve as the secondary isolation module. The voltage regulation circuit is a signal processing circuit primarily configured to regulate a voltage to a target input voltage for the second transformer T2. This voltage regulation circuit regulates a voltage signal to facilitate processing by a next-stage module. The diode module includes at least two diodes, and the diode can enable rectification of voltage/current signal and adjust the voltage/current signal to an input signal suitable for a next-stage module. The voltage stabilizer U1 may employ a low-dropout voltage stabilizer to reduce an input voltage, convert the input voltage to the target operating voltage for the high-voltage acquisition unit 11, thereby providing a stable operating voltage for the high-voltage acquisition unit 11.

Within the communication isolation unit 12 according to some embodiments, the third transformer T3 and the fourth transformer T4 may employ transformers with either a 1:2 turns ratio or a 1:1 turns ratio. A creepage distance of each of the third transformer T3 and the fourth transformer T4 must be greater than or equal to a preset insulation threshold. Furthermore, a sum of the creepage distances of the third transformer T3 and the fourth transformer T4 must be greater than or equal to a target insulation threshold for a dual-transformer configuration. In the embodiments, the third transformer T3 serves as the primary isolation module of the communication isolation unit 12, while the fourth transformer T4 serves as the secondary isolation module of the communication isolation unit 12. The bridge chip is an integrated circuit configured to bridge different communication protocols interfaces, ensuring the data can be seamlessly transferred between different devices or systems.

In the embodiments, a dual-transformer isolation is employed in each of the power circuit and communication circuit between the high and low voltage sides of the energy storage battery management system. The dual-transformer isolation in the power circuit includes primary isolation achieved by the first transformer T1 and secondary isolation achieved by the second transformer T2. In the communication circuit, the dual-transformer isolation includes primary isolation achieved by the third transformer T3 and secondary isolation achieved by the fourth transformer T4. This configuration meets safety requirements for the energy storage battery management system with the management voltage between 2000V and 2500V, enhancing the reliability and stability of such system.

Optionally, the power isolation unit 10 connects to the high-voltage acquisition unit 11, which in turn connects to the communication isolation unit 12.

Within the power isolation unit 10, the low-voltage power supply VCC is connected to the first transformer T1. The first transformer T1 is connected to the voltage regulation circuit, which is further connected to the second transformer T2. The second transformer T2 is connected to the diode module, which is connected to the voltage stabilizer U1. The voltage stabilizer U1 provides the target operating voltage HV_VDD5 to the high-voltage acquisition unit 11.

In some embodiments, the first transformer T1 has six pins, where the second pin is connected to the low-voltage power supply VCC, and the fourth, fifth and sixth pins are connected to the voltage regulation circuit. The second transformer T2 has six pins, where the first, second and third pins are connected to the voltage regulation circuit, the fourth and sixth pins are connected to the diode module, and the fifth pin is left unconnected. The voltage stabilizer U1 has five pins, where the first pin is an input terminal IN, the second pin is an enable terminal EN, the third pin is a ground terminal GND, the fourth pin FB/NC is left unconnected, and the fifth pin is an output terminal OUT. The diode module may include diodes D1, D2, D3, and D4.

In some embodiments, the high-voltage acquisition unit 11 is connected to the third transformer T3 within the communication isolation unit 12. Within the communication isolation unit 12, the third transformer T3 is connected to the fourth transformer T4, and the fourth transformer T4 is connected to the bridge chip, which may be further connected to the MCU.

In some embodiments, the third transformer T3 has three input pins and three output pins, where the fourth and sixth pins, which serve as input pins, are connected to the high-voltage acquisition unit 11; the fifth pin, which serves as an input pin, is connected to a negative terminal HV_BAT- of the battery cluster (also serving as a reference ground terminal of the high-voltage acquisition unit 11) via a filter capacitor C6; the first and third pins, which serve as output pins, are connected to the fourth transformer T4; and the second pin, which serves as an output pin, is left unconnected. The fourth transformer T4 also has three input pins and three output pins, where the fourth and sixth pins, which serve as input pins, are connected to the third and first pins of the third transformer T3, respectively; and the second pin, which serves as an output pin, is grounded via a filter capacitor C5.

Optionally, the creepage distance of each of the first transformer T1, the second transformer T2, the third transformer T3 and the fourth transformer T4 is greater than or equal to a preset insulation threshold. The sum of the creepage distances of the first transformer T1 and second transformer T2 is greater than or equal to the dual-transformer target insulation threshold, and the sum of the creepage distances of the third transformer T3 and the fourth transformer T4 is greater than or equal to the dual-transformer target insulation threshold.

During the execution of tasks on the energy storage system, external operators may come into contact with low-voltage components or a casing of an electrical device. By implementing the aforementioned high-low voltage isolation scheme within the energy storage battery management system, it ensures that a high voltage is not introduced to low-voltage components or the casing of the electrical device. This guarantees external operators will not come into contact with the high voltage, thereby protecting them from injury.

The creepage distance between high and low voltages in the energy storage battery management system is critical for safe operations of the energy storage battery management system. If the creepage distance is too small, it may cause a breakdown between the high-voltage and low-voltage windings, leading to device damages or even safety incidents. Therefore, the creepage distance of each of the first transformer T1, the second transformer T2, the third transformer T3 and the fourth transformer T4 must be greater than or equal to a preset insulation threshold. In the embodiments, the preset insulation threshold may be 18 mm. Simultaneously, to ensure the safe and stable operation of the energy storage battery management system with a management voltage of 2000V to 2500V, the sum of the creepage distances of the first transformer T1 and the second transformer T2 must be greater than or equal to a dual-transformer target insulation threshold, and the sum of the creepage distances of the third transformer T3 and the fourth transformer T4 must be greater than or equal to the dual-transformer target insulation threshold. In the embodiments, the dual-transformer target insulation threshold may be 36 mm. Based on the above criteria, the first transformer T1, the second transformer T2, the third transformer T3 and the fourth transformer T4 in the embodiments may employ transformers with a creepage distance greater than or equal to 21 mm. This ensures a creepage distance greater than or equal to 42 mm when the dual-transformer isolation is used, satisfying the insulation standard of creepage distance for the energy storage battery management system with the management voltage of 2000 V to 2500 V using the high-low voltage isolation.

Optionally, the power isolation unit 10 shown in FIG. 2 may further include a push-pull chip U2 and a filter component. The push-pull chip U2 is connected to the low-voltage power supply VCC to receive the voltage signal from the low-voltage power supply VCC. By alternately turning-on power switch transistors inside the push-pull chip U2, the push-pull chip U2 controls the forward or reverse flow of current, thereby controlling the energy conversion and transmission of the low-voltage power supply VCC. The filter component may include filter capacitors C1, C2, C3 and C4 along with a filter inductor L1, which filter the voltage signals transmitted within the power isolation unit 10.

In the embodiments, the battery cluster information acquired by the high-voltage acquisition unit 11 may include a total voltage, a total current, and a total insulation value of the battery cluster. The total voltage of the battery cluster corresponding to the energy storage battery management system with a management voltage of 2000V to 2500V is 2000V to 2500V. The high-voltage acquisition unit 11 is configured to acquire the battery cluster information and convert it into a digital signal format. The battery cluster information in the digital signal format can be transmitted to the MCU via the communication isolation unit 12, enabling the MCU to generate and issue a control instruction based on the received battery cluster information.

According to the embodiments, the battery cluster can be evaluated based on the battery cluster information acquired by the high-voltage acquisition unit 11. For example, the operational status of the battery cluster can be evaluated by calculating its state of charge based on the total voltage and total current of the battery cluster. Additionally, the current health level and lifespan status of the battery cluster can be evaluated by calculating its health status value based on the total voltage and total insulation value of the battery cluster.

Optionally, the communication isolation unit 12 may further include a MCU for receiving battery cluster information and generating the control instruction for the battery cluster based on the battery cluster information, where the control instruction may include a battery cluster charging instruction and a battery cluster discharging instruction.

In the embodiments, the communication isolation unit 12 may further include a MCU and a filter component including filter capacitors C5 and C6. The MCU is a control chip configured for receiving the battery cluster information, generating a corresponding control instruction for the battery cluster based on parameters such as the total voltage, total current and total insulation value within the battery cluster information, and issuing the instruction to a next-stage module for implementation of a corresponding control operation. For example, the MCU can determine whether a discharging or charging current of the current battery cluster is excessively high or low based on the total current of the battery cluster, and then issue the charging or discharging instruction to regulate the charging/discharging current of the battery cluster.

In the embodiments, the low-voltage signal from the low-voltage power supply VCC undergoes the dual-transformer isolation of the first transformer T1 and the second transformer T2, and is converted by the voltage stabilizer U1 into the target operating voltage HV_VDD5 to supply power to the high-voltage acquisition unit 11. The high-voltage acquisition unit 11 acquires the battery cluster information such as the total voltage, total current and total insulation value of the battery cluster, converts the battery cluster information into a digital signal. Subsequently, the battery cluster information undergoes the dual-transformer isolation of the third transformer T3 and the fourth transformer T4, then is transmitted through a daisy-chain communication to the bridge chip. The bridge chip converts the battery cluster information into a synchronous serial communication format and transmits it to the MCU via the serial peripheral interface (SPI) bus, enabling the MCU to generate the control instruction for the battery cluster based on the battery cluster information.

More specifically, according to some embodiments, a voltage signal from the low-voltage power supply VCC is transmitted to the first transformer T1 and the push-pull chip U2 during the operation of the power isolation unit 10. The first transformer T1 performs primary isolation on the voltage signal, transforms it into a first voltage and supplies the first voltage to the voltage regulation circuit, where the first voltage is a DC voltage. The voltage regulation circuit regulates the first voltage to a target input voltage for the second transformer T2 and transmits it to the second transformer T2. The second transformer T2 performs secondary isolation on the received voltage and couples it to the diode module, where the diode module includes at least two diode elements. The diode module rectifies the received voltage into a target input voltage for the voltage stabilizer U1 and transmits it to the voltage stabilizer U1. The voltage stabilizer U1 converts the received voltage into a target operating voltage HV_VDD5 for the high-voltage acquisition unit 11 to supply power to the high-voltage acquisition unit 11.

In some embodiments, the high-voltage acquisition unit 11 acquires the battery cluster information in an analog signal format, converts the battery cluster information into a digital signal format, and transmits the battery cluster information in the digital signal format to the MCU through a daisy-chain communication which is a serial communication method. Specifically, the third transformer T3, the fourth transformer T4, the bridge chip and the MCU constitute a daisy-chain communication structure, enabling the battery cluster information to be sequentially transmitted to the MCU via the third transformer T3, the fourth transformer T4 and the bridge chip.

More specifically, according to some embodiments, the sixth and fourth pins of the third transformer T3 receive the battery cluster information in the digital signal format output by the high-voltage acquisition unit 11 during the operation of the communication isolation unit 12. The third transformer T3 performs primary isolation on the battery cluster information and couples it to its first and third pins to transmit the battery cluster information to the sixth and fourth pins of the fourth transformer T4. The fourth transformer T4 receives the battery cluster information through its sixth and fourth pins, performs secondary isolation on the battery cluster information, and couple the battery cluster information to its first and third pins to transmit the battery cluster information to the bridge chip. The bridge chip converts the battery cluster information into a synchronous serial communication format and transmits the battery cluster information in the synchronous serial communication format to the MCU via the SPI bus, enabling the MCU to generate the control instruction for the battery cluster based on the battery cluster information.

It should be noted that converting the battery cluster information into the synchronous serial communication format enhances the transmission efficiency of the battery cluster information. Furthermore, the synchronous serial communication protocol is relatively simple, which facilitates the implementation and maintenance of the transmission of the battery cluster information.

It should be noted that the bridge chip in the embodiments complies with a daisy chain communication protocol, and enables the daisy chain communication of the battery cluster information. By adopting the daisy chain communication, the transmission efficiency of the battery cluster information can be improved.

According to the embodiments, the above solution addresses the high-low voltage isolation issue in the energy storage battery management system with the management voltage ranging from 2000V to 2500V, thereby improving the voltage level of the energy storage battery management system.

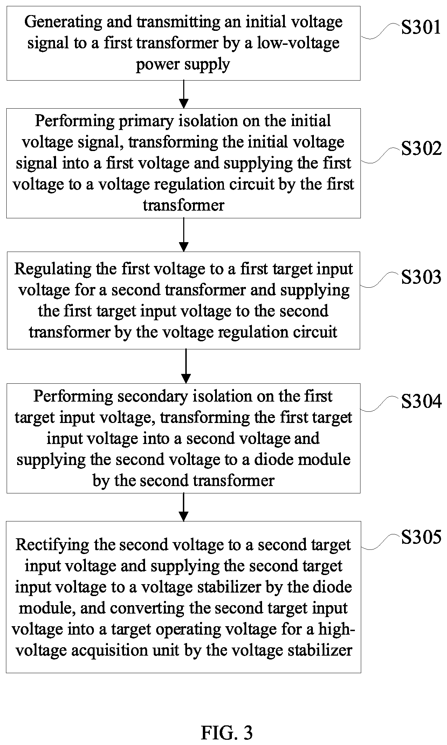

FIG. 3 is a flowchart of a power isolation method in an energy storage battery management system according to some embodiments of the present application. The power isolation method shown in FIG. 3 may include steps S301 to S305.

In step S301, the low-voltage power supply generates an initial voltage signal and transmits it to the first transformer.

In step S302, the first transformer performs primary isolation on the initial voltage signal, transforms it into a first voltage and supplies it to the voltage regulation circuit, where the first voltage is a DC voltage.

In step S303, the voltage regulation circuit regulates the first voltage to a first target input voltage for the second transformer and supplies it to the second transformer.

In step S304, the second transformer performs secondary isolation on the first target input voltage, transforms it into a second voltage and supplies it to the diode module, where the diode module includes at least two diode elements.

In step S305, the diode module rectifies the second voltage into a second target input voltage and supplies it to the voltage stabilizer, which converts the second target input voltage into the target operating voltage for the high-voltage acquisition unit.

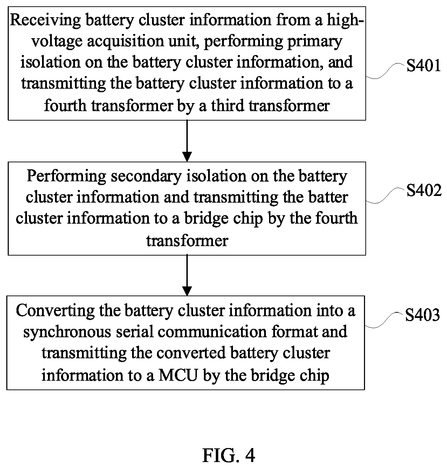

FIG.4 is a flowchart of a communication isolation method in an energy storage battery management system according to some embodiments of the present application. The communication isolation method shown in FIG. 4 may include steps S401 to S403.

In step S401, the third transformer receives the battery cluster information from the high-voltage acquisition unit, performs primary isolation on the battery cluster information, and transmits the battery cluster information to the fourth transformer.

In step S402, the fourth transformer performs secondary isolation on the battery cluster information and transmits it to the bridge chip.

In step S403, the bridge chip converts the battery cluster information into a synchronous serial communication format and transmits the converted battery cluster information to the MCU.

## Claims

1. An energy storage battery management system comprising a power isolation unit, a high-voltage acquisition unit and a communication isolation unit,
wherein the power isolation unit comprises a first transformer and a second transformer and is configured to: subject an initial low-voltage signal to primary isolation by the first transformer and secondary isolation by the second transformer in sequence, to obtain a second voltage; convert the second voltage to a target operating voltage of the high-voltage acquisition device; and supply the target operating voltage to the high-voltage acquisition unit;
the high-voltage acquisition unit is configured to: acquire battery cluster information of a battery cluster; convert the battery cluster information into a digital signal format; and provide the battery cluster information in the digital signal format to the communication isolation unit; and
the communication isolation unit comprises a third transformer and a fourth transformer and is configured to: transmit the battery cluster information in the digital signal format to a microcontroller unit (MCU) through primary isolation by the third transformer and secondary isolation by the fourth transformer in sequence, to enable the MCU to generate a control instruction for the battery cluster based on the battery cluster information.

2. The energy storage battery management system according to claim 1, wherein the power isolation unit further comprises a low-voltage power supply, a voltage regulation circuit, a diode module and a voltage stabilizer;
the low-voltage power supply is configured to supply the initial low-voltage signal to the first transformer;
the first transformer is configured to transform the initial low-voltage signal into a first voltage and supply the first voltage to the voltage regulation circuit, wherein the first voltage is a direct current (DC) voltage;
the voltage regulation circuit is configured to regulate the first voltage to a first target input voltage and supply the first target input voltage to the second transformer;
the second transformer is configured to transform the first target input voltage into the second voltage and supply the second voltage to the diode module;
the diode module is configured to rectify the second voltage into a second target input voltage and supply the second target input voltage to the voltage stabilizer; and
the voltage stabilizer is configured to convert the second target input voltage into the target operating voltage and supply the target operating voltage to the high-voltage acquisition unit.

3. The energy storage battery management system according to claim 2, wherein the power isolation unit further comprises:
a push-pull chip configured to receive the initial low-voltage signal, and to control energy conversion and transmission of the low-voltage power supply by alternately turning-on power switch transistors inside the push-pull chip; and
a first filter component comprising a filter capacitor and a filter inductor, and configured to filter a voltage signal transmitted within the power isolation unit.

4. The energy storage battery management system according to any one of claims 1-3, wherein the communication isolation unit further comprises a bridge chip;
the third transformer is configured to transmit the battery cluster information in the digital signal format from the high-voltage acquisition unit to the fourth transformer;
the fourth transformer is configured to transmit the battery cluster information in the digital signal format from the third transformer to the bridge chip; and
the bridge chip is configured to convert the battery cluster information in the digital signal format from the fourth transformer into a synchronous serial communication format, and transmit the converted battery cluster information to the MCU.

5. The energy storage battery management system according to claim 4, wherein the communication isolation unit further comprises a second filter component.

6. The energy storage battery management system according to any one of claims 1-5, wherein each of the first transformer, the second transformer, the third transformer and the fourth transformer has a creepage distance greater than or equal to a preset insulation threshold;
a sum of the creepage distance of the first transformer and the creepage distance of the second transformer is greater than or equal to a dual-transformer target insulation threshold; and
a sum of the creepage distance of the third transformer and the creepage distance of the fourth transformer is greater than or equal to the dual-transformer target insulation threshold.

7. The energy storage battery management system according to any one of claims 1-6, wherein the battery cluster information comprises at least one of a total voltage of the battery cluster, a total current of the battery cluster and a total insulation value of the battery cluster.

8. The energy storage battery management system according to any one of claims 1-7, wherein the control instruction comprises at least one of a charging instruction and a discharging instruction.

9. The energy storage battery management system according to any one of claims 1-8, wherein each of the third transformer and the fourth transformer has three input pins and three output pins, a first one of the three output pins of the third transformer is connected to a first one of the three input pins of the fourth transformer, and a third one of the three output pins of the third transformer is connected to a third one of the three input pins of the fourth transformer.

10. The energy storage battery management system according to any one of claims 1-9, wherein the high-voltage acquisition unit is configured to transmit the battery cluster information in the digital signal format to the MCU through daisy-chain communication.
